# EUROPEAN PATENT APPLICATION

(11) **EP 1 760 514 A1**
(43) Date of publication of application: **07.03.2007**
(21) Application number: 05425621.9
(22) Date of filing: 05.09.2005
(51) Int. Cl.: G02B 26/12, G06K 7/10, H02K 11/00

(54) **Scanning device for an optical code reader**

(71) Applicant: DATALOGIC S.P.A., 40012 Lippo di Calderara di Reno (Bologna) (IT)
(72) Inventor: Ciabattoni, Stefano, 40137 Bologna (IT); Comte, Vincent, 1009 Pully (CH)
(74) Representative: Bottero, Claudio

(57) **Abstract**

A scanning device (40, 40') for an optical code reader (1) is described, comprising a printed circuit board (2), an electric motor (42) having a stator (44), a magnetic rotor (43) and a plurality of coils (64), and a polygonal mirror (41) integral with the rotor (43) of the motor (42), characterized by having a support (66) of the coils (64) adjacent to the side of the printed circuit board (2) opposite the magnetic rotor (43) to keep said plurality of coils (64) in positions corresponding to a plurality of holes (65, 65') of the printed circuit board (2).

## Description

The present invention concerns a scanning device for an optical code reader, in particular a barcode reader, as well as a scanning section and an optical code reader containing it.

As known, in an optical code reader, in particular a black and white or colour barcode and stacked code reader, a beam of collimated light (not necessarily in the visible range), like for example a laser light beam or the beam of an uncollimated light source, collimated through suitable collimating optics, is moved in a plane, called scanning plane, so as to form a scanning line that crosses the optical code. The light diffused by the optical code when it is illuminated by the scanning line is detected by a photodetector device, which transforms it into a time-variable electrical signal, whose intensity represents the elements of the optical code, for example the bars and the spaces in the case of barcodes.

For the movement of the beam of collimated light to form the scanning line a scanning device is typically used comprising a rotary motor that drives a rotary polygonal mirror into rotation, in other words a polyhedron with polygonal base the faces of whose side surface are mirrorly reflective. The collimated light beam, directed towards the polygonal mirror in a non-radial direction, is deflected by a face thereof and, because of the rotation of the mirror, sweeps a certain angle in a plane, called scanning plane. At the corner between one face and the adjacent one, the collimated light beam starts to sweep the same angle again. On the plane of the optical code, the spot of collimated light therefore crosses, in conditions of perfect alignment, a same scanning line in a rapid succession of times.

Miniaturized optical codes readers are increasingly required, for example for applications in which the optical code reader is a component of complex automatic systems, such as automatic machines, where it is essential for all of the components to have the minimum possible bulk.

In miniaturized optical code readers a non retroreflective configuration is typically used, wherein the scanning device and in particular its mirror faces are not used to collect the light diffused by the optical code and therefore can have a size of an order of magnitude of the size of the laser spot incident on each face.

EP 1 207 489 A2 describes a scanning device for an optical code reader comprising a flat electric motor, comprising a substantially hollow disc-shaped stator, which houses windings and a magnetic rotor coaxially inner to the windings and supported by a drive shaft, projecting from the stator. A polygonal mirror is integrally attached to the projecting portion of the drive shaft outside the stator. The motor-polygonal mirror assembly is housed in a dedicated casing, to which the ends of the drive shaft are fixed.

Although the scanning device of such a document has a notably small size, it is an independent component, whose casing must be assembled in the reader, through cables and fastening points typically by welding.

EP 1 115 022 A2 discloses a scanning device for an optical code reader comprising an electric motor having a tube shaped stator with a coaxially outer coil and a shaft rotating inside bearings of the stator, which supports a polygonal mirror and a magnet fixed inside the polygonal mirror, externally or on top coaxial with the coil, wherein the stator is fixed to the printed circuit board with the coil resting upon the printed circuit board.

The scanning device of such a document, though without casing, is unsuitable for using a plurality of coils, a configuration that on the other hand allows a more uniform rotation of the rotor of the motor and thus of the polygonal mirror.

The technical problem at the basis of the present invention is to provide a scanning device for an optical code reader that occupies a small useful space still allowing a uniform rotation of a polygonal mirror.

In a first aspect thereof, the invention concerns a scanning device for an optical code reader, comprising a printed circuit board, an electric motor having a stator, a magnetic rotor and a plurality of coils, and a polygonal mirror integral with the rotor of the motor, characterized by having a support of the coils adjacent to the side of the printed circuit board opposite the magnetic rotor to keep said plurality of coils in positions corresponding to a plurality of holes of the printed circuit board.

Such a scanning device is an integral part of the printed circuit board that penetrates it, rendering a casing superfluous for containing the plurality of coils, which ensure a uniform rotation of the polygonal mirror. The bulk of the scanning device on one side of the printed circuit board is therefore reduced, while the small bulk of the support of the coils is on the other side of the printed circuit board, where connectors and fastening screws of the various components are in any case typically provided.

During its integration in an optical code reader, the scanning device can also be easily manipulated through the printed circuit board.

Welding points and an additional assembly step are also avoided, since the motor is assembled directly onto the printed circuit board.

In an embodiment, the support has a corresponding plurality of pins projecting from the holes of the printed circuit board, the coils being inserted on the pins.

In such a way the coils rest upon the printed circuit board, kept in the correct position by the pins of the support.

Preferably, the pins have a non-circular, more preferably triangular cross section, and the hole of the coils has a corresponding shape.

In such a way it is possible to easily control the correct alignment of the coils in an overall axially symmetric configuration.

In other embodiments, the holes of the printed circuit board are each sized to receive a respective coil.

In such a way, the coils are totally or partially recessed in the printed circuit board, with further saving of space.

The support can act simply as a coil holder.

Preferably, however, in this case also the support has a corresponding plurality of pins that are however completely received in the holes of the printed circuit board to create seats for receiving the coils, without however projecting therefrom.

The pins can again have a non-circular, more preferably triangular cross section, the hole of the coils having a corresponding shape.

Analogously, the holes of the printed circuit board each sized to receive a coil can have a non-circular, more preferably triangular cross section, the outer cross section of the coils having a corresponding shape.

The motor is preferably of the fixed shaft type, but it could be of the rotary shaft type.

The polygonal mirror can have faces of different inclination with respect to its rotation axis, to generate a raster-type scanning pattern for reading stacked codes or for a reading based upon reconstruction techniques of codes randomly oriented with respect to the reader.

In a second aspect thereof, the invention concerns a scanning section of an optical code reader, comprising a scanning device as described above and an emitter of a reading light beam.

The beam emitter is typically a laser emitter.

In case however the light beam emitted by the emitter is not collimated, like for example in case of an LED source, the scanning section can further comprise a collimating optics of the reading light beam.

In a third aspect thereof, the invention concerns an optical code reader comprising a scanning device as described above.

The invention shall be better described hereafter with reference to some embodiments and examples, based on the attached drawings, wherein corresponding elements are designated by similar numbers. In the drawings:
- Fig. 1 illustrates a miniaturized optical code reader according to the invention, in a partially assembled state,
- Fig. 2 illustrates the reader of Fig. 1 in an assembled state,
- Fig. 3 illustrates the reader of Fig. 1 in an assembled state and with protective casing,
- Fig. 4 illustrates an exploded perspective view of a scanning section of the reader of Fig. 1,
- Figs. 5 and 6 illustrate a first embodiment of a scanning device according to the invention, respectively in perspective and in sectional view,
- Figs. 7 and 8 illustrate a detail of the scanning device of Figs. 5 and 6,
- Fig. 9 illustrates a second embodiment of a scanning device according to the invention, in sectional view, and
- Figs. 10 and 11 illustrate a detail of the scanning device of Fig. 9.

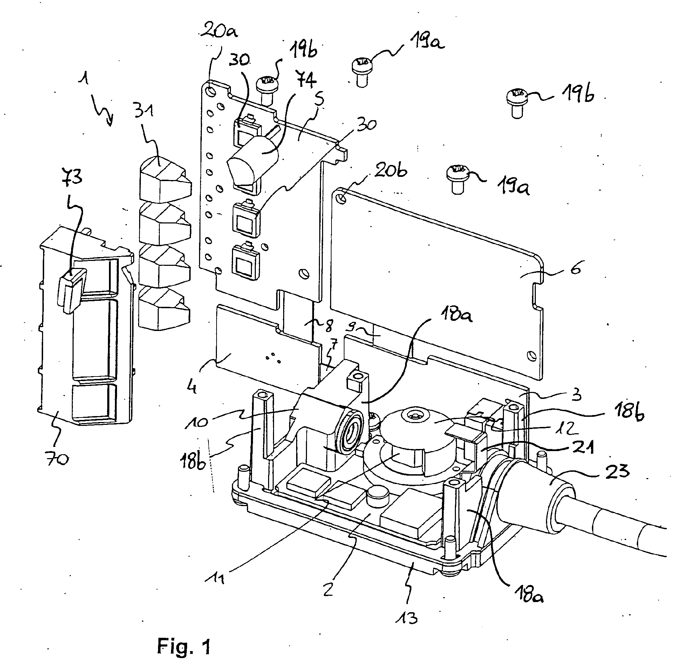

In figures 1-3 a miniaturized optical code reader 1 is illustrated, of a size 40mm x 30mm x 22mm (volume of about 27cm³).

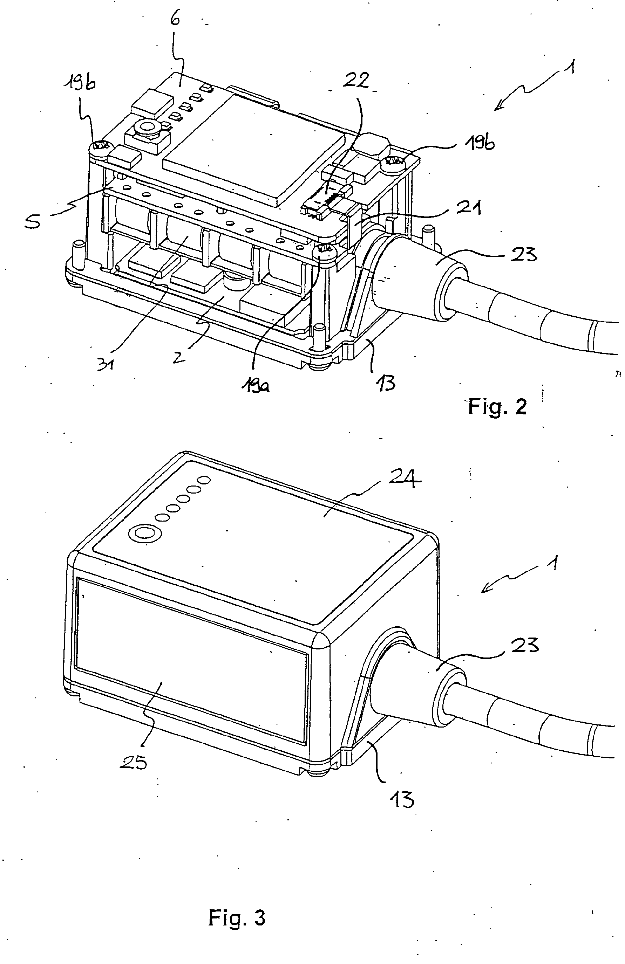

The reader 1 comprises a first PCB 2 and a second PCB of the rigid/flexible type, made up of four rigid portions or circuits 3, 4, 5, 6 connected together by three flexible connections 7, 8, 9 that allow the PCB to be bent so that the circuits 3, 4, 5, 6 are arranged at an angle (figure 2) and form, with the first PCB 2, four of the six faces of a rectangular parallelepiped. On the first PCB 2 a device for scanning the laser beam emitted by a laser emitter 10 is formed. The scanning device, better described hereafter, comprises a polygonal mirror 11 driven into rotation by a motor 12 and the electronics for driving the motor 12.

The rotary polygonal mirror 11 can have the faces with different inclinations for reading stacked codes.

The back circuit 3 of the second PCB is the input/output circuit (I/O) of the reader 1. Back, like other terms hereafter, is used merely to ease the description and with reference to the orientation of figures 1-3. The back circuit 3 of the second PCB is connected, through the flexible connection 7, to the circuit 4 of the second PCB, on the side in the assembled reader 1.

The side circuit 4 is the driving circuit of the laser emitter 8. The side circuit 4 of the second PCB is in turn connected, through the flexible connection 8, with the third circuit 5 of the second PCB, on the top and inner in the assembled reader 1 (figure 2).

On the top inner circuit 5 of the second PCB a receiving section is made, not better described hereafter, comprising a plurality of photodetector devices 30, in particular photodiodes, a corresponding plurality of optical receiving devices 31 and the electronics (not shown) for driving the photodetecting devices 30 and possibly for pre-processing the signal emitted by them.

The back circuit I/O 3 of the second PCB is further connected, through the flexible connection 9, to the circuit 6 carrying the reading and/or decoding electronics, which in the assembled reader 1 is on the top and outer (figure 2).

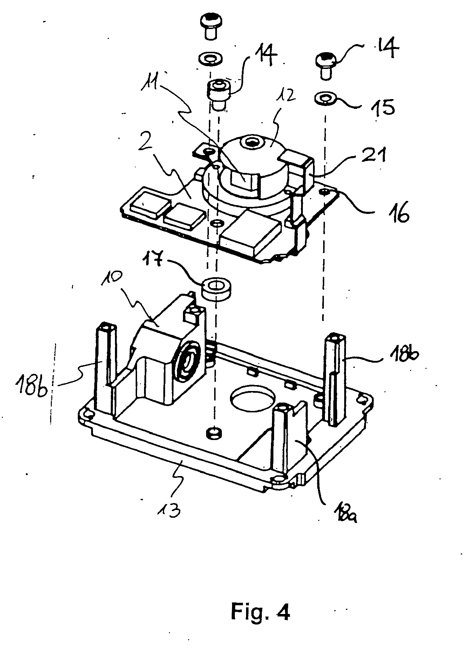

As can be seen more clearly in figure 4, the first PCB 2 is fixed to a support base 13 through screws 14 and washers 15 passing in respective holes 16 of the PCB 2. At one of the screws, the front one in figure 4, an elastic ring 17 is placed between the PCB 2 and the support base 13.

When, like in the illustrated embodiment, the laser emitter 10 is fixed to the support base 13 and not to the PCB 2, the elastic ring 17, by adjusting the degree of tightness of the screw 14, allows the inclination of the PCB 2 to be adjusted with respect to the emission plane of the laser beam by the emitter 10, thus allowing an optimal alignment between the rotary polygonal mirror 11 and the scanning laser ray, and between the emission plane of the laser beam and the line of view of the receiving optics formed on the top inner circuit 5 of the second PCB.

Moreover, the elastic ring 17 elastically deforms under the tightening action of the screw 14 and allows possible vibrations transmitted to the PBC 2 from the support base 13 to be absorbed at least in part.

Analogous elastic rings can also be provided at the other screws 14.

The support base 13 is provided, in proximity to the four corners, with four posts 18a, 18b. More specifically, the two posts 18a arranged according to a diagonal of the support base 13 are of a lower height than the two posts 18b arranged according to the other diagonal of the support base 13. The top inner circuit 5 of the second PCB rests upon the posts 18a of lower height and is fixed there through screws 19a passing in holes 20a of the receiving circuit 5. The top outer circuit 6 of the second PCB rests upon the posts 18b of greater height and is fixed there through screws 19b passing in holes 20b of the receiving circuit 5.

The first PCB 2 is connected to the second PCB, and in particular to its top outer circuit 6, through a flat flexible cable (FFC) 21 that engages in suitable connectors, the connector 22 provided on the top outer circuit 6 of the second PCB being visible in figure 2, while the connector provided on the first PCB 2 cannot be seen since it is on the bottom side thereof.

A cable 23 for supplying power and for signal input/output is connected to the support base 13.

Figure 3 illustrates a cover 24 that couples on the support base 13 to form a protective casing of the reader 1. The cover 24 is provided with an emission/receiver window 25 that, in the mounted state of the reader 1, faces the receiving section and the emitting and scanning section, to allow output of the laser light emitted by the emitter 10 and scanned by the rotary polygonal mirror 11 and input of the light diffused by the optical code when illuminated by such scanned laser light. The emission/receiver window 25 can also incorporate or comprise a high-pass optical filter (i.e. that allows light with great wavelengths to pass) or low-pass optical filter for rejecting the ambient light, for example having a pass band of 580-700 nm. In an alternative embodiment, the casing consisting of the base 13 and the cover 24 can be missing, the first PCB 2 of the reader 1 in such a case being fixed directly in any apparatus, preferably with the interposition of the elastic ring 17 as described above for protection against shocks and vibrations. In case the casing is not provided, the laser emitter 10 and the posts 18a, 18b are directly fixed onto the first PCB 2 and the emission/receiver window 25, as well as the possible filter, are fixed, for example by gluing, between the first PCB 2 and the top inner circuit 5 of the second PCB. It should be understood that a filter thus fixed between the first PCB 2 and the top inner circuit 5 can also be provided in case of use of the casing 13, 24, as an alternative to its arrangement at the emission/receiver window 25.

Making the reader 1 through the two PCBs one of which can be bent as described above is advantageous since in the unassembled state the reader 1 can be laid flat and easily protected, packaged, stored and sent. The flexible connections 7, 8, 9, also allow a particularly compact arrangement of the electronics around the optics of the reader 1.

It should be understood that a single PCB could also be provided, on which the scanning circuit is also made, connected through a flexible connection to the back circuit 3 or to the side circuit 4.

As shall be manifest to those skilled in the art, the illustrated reader 1 is of the non-retroreflective type, the optimal configuration for miniaturized readers since it allows the size of the optical scanning device (the polygonal mirror 11 in the illustrated embodiment) to be minimized reducing it to the order of magnitude of the size of the laser spot incident on each face.

More specifically, the size of each face of the polygonal mirror 11 is typically about three times the width of the laser spot incident on it in the direction perpendicular to the rotation axis of the polygonal mirror 11, and it is about twice the width of the laser spot in the direction of the rotation axis.

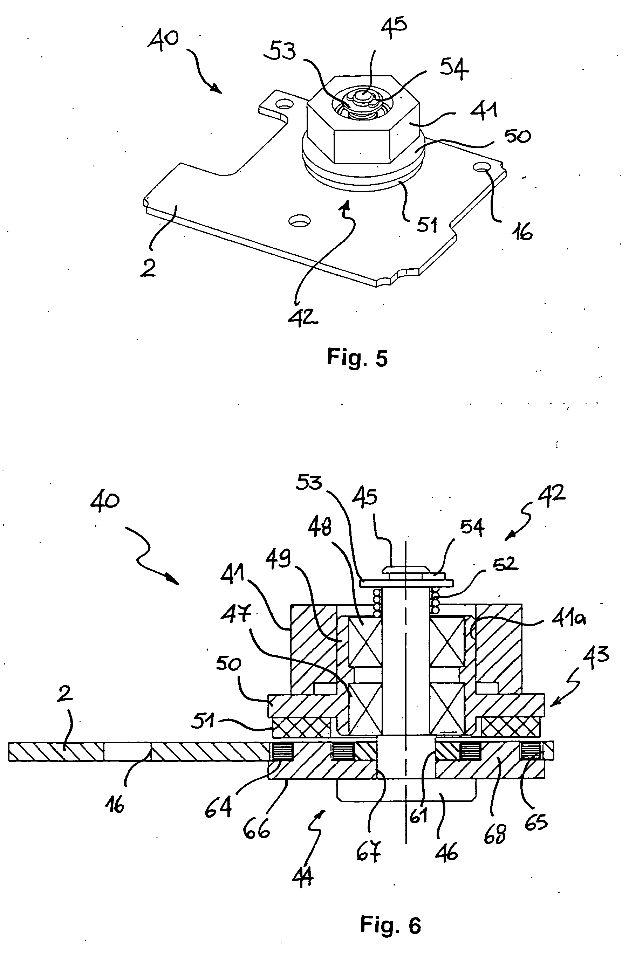

In figures 5 and 6 a first embodiment of a scanning device 40 is illustrated, in perspective and in sectional view respectively.

The scanning device 40 comprises a fixed shaft electric motor, indicated there with reference numeral 42 and a polygonal mirror, indicated there with reference numeral 41, integral with a rotor 43 of the motor 42.

A stator 44 of the motor comprises a shaft 45 with disc-shaped end 46, inserted in a hole 61 of the bottom PCB 2 on its bottom side, with interposition of a support 66 of a plurality of coils 64 better described hereafter.

The inner rings of a pair of roller bearings 47, 48 are integrally attached to the portion of the shaft 45 of the stator 44 projecting from the PCB 2.

The rotor 43, in the form of a cap 49 provided with a flange 50 to which magnets 51 are fixed on the side towards the PCB 2 and therefore towards the coils 64, is integrally attached to the outer rings of the bearings 47, 48.

On the other side of the flange 50, the polygonal mirror 41 is slid around the cap 49, which extends in a hole 41a of the polygonal mirror 41.

The polygonal mirror 41 is coupled with the cap 49 with slight interference and is preferably locked on it through gluing.

A compression spring 52 extending around the shaft 45 above the polygonal mirror 41 maintains the position of the rotor 43 and of the polygonal mirror 41 and ensures the preloading on the bearings 47, 48 for recovering possible internal clearances.

The stator 44 and the rotor 43 are finally fixed through a washer 53 and a Seger ring 54.

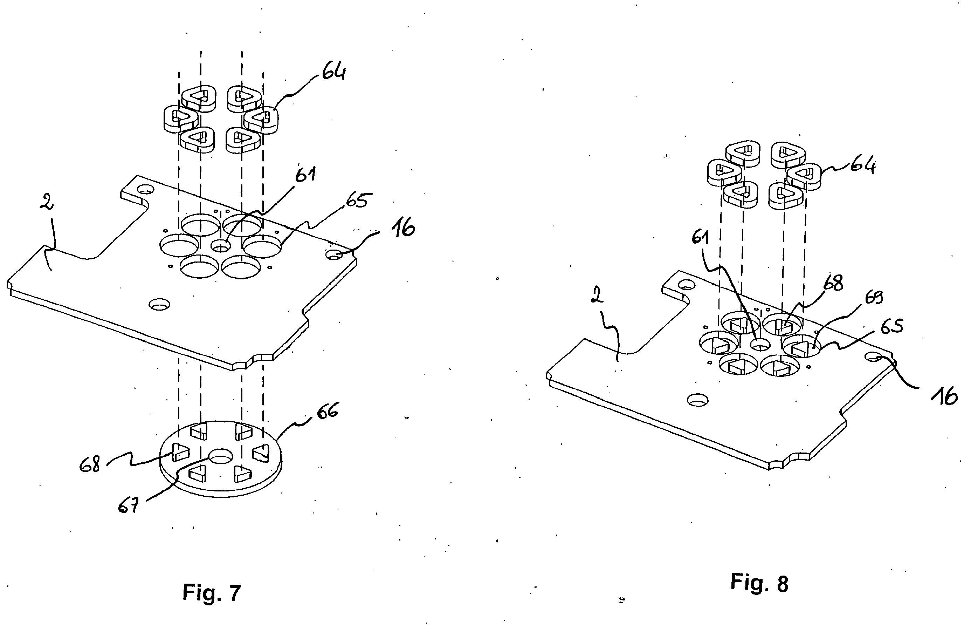

In figures 7 and 8 the PCB 2, the support 66 and the coils 64 are illustrated in exploded perspective and in partially exploded perspective views.

A plurality of holes 65 are formed in the PCB 2, in a regular arrangement about the hole 61 for receiving the shaft 45 of the stator 44 of the motor 42, sized to each receive a coil 64.

The support 66 is in the form of a thin disc, provided with a central hole 67 and with a plurality of pins 68 according to a corresponding regular arrangement about the central hole 67.

As can be seen in figure 8, when the support 66 is arranged on the side of the PCB 2 opposite the side of the rotor 43, its pins 68 are each inserted in one of the holes 65 of the PCB 2 and its hole 67 is aligned with the hole 61 of the PCB 2, for the passage of the shaft 45.

The pins 68 have a smaller section that the section of the holes 65 of the PCB 2, and a thickness substantially corresponding to or less than the thickness of the PCB 2, so that the pins 68 are completely received in the holes 65 of the PCB 2.

Between each pin 68 and the wall of the corresponding hole 65 of the PCB 2 a seat 69 for receiving a coil 64 is therefore formed, which is thus recessed in the PCB 2.

The coils are preferably preformed and rested or glued in the respective seats 69.

Although preferably the coils 64 are totally recessed in the PCB 2 as shown in figure 6, they could be only partially recessed, projecting from the PCB 2.

In the illustrated embodiment, the pins 68 have a triangular section, like the inner hole of the coils 64, so that the coils 64 can be mounted in an axially symmetric configuration only. Matching sections of other non-circular shapes are equally suitable in order to ensure the correct assembly of the coils 64, but a circular section can of course be provided, taking the due care in the assembly step of the coils 64.

As an alternative or in addition to the section of the pins 68, the section of the holes 65 of the PCB 2 could be non-circular, of a shape corresponding to the outer section of the coils 64 (for example triangular in case of triangular coils 64).

It should also be understood that, especially in case the holes 65 of the PCB are thus shaped, the pins 68 can be missing altogether, the coils 64 being in any case held in the holes 65 of the PCB 2 by the support 66, to which they can be glued.

The entire motor 42 described above is an integral part of the PCB 2 that it penetrates. The bulk of the scanning device 40 is extremely small thanks to the arrangement of the coils 64 embedded in the PCB and to the absence of a casing of the motor. Indeed, it should be noted that the support 66 of the coils 64 has a slight bulk, but on the opposite side of the PCB 2 (bottom side in figure 6), where the bulk of the flat flexible cable 21 and possibly of the elastic ring 17 and more generally in any case of connectors and fastening screws of the components of a printed circuit board on which the scanning device 40 is fixed is in any case provided.

In the assembly step of the reader 1, it is not necessary to directly manipulate the motor and the associated polygonal mirror 41, what would be difficult due to the miniaturized size, instead it being possible to grip the PCB 2. Welding points and an additional assembly step are also avoided, since the motor 42 is assembled directly onto the PCB 2.

In case the emitter of collimated light, for example the laser emitter 10, is formed on the PCB 2 itself, the alignment of the light beam with the polygonal mirror 41 is easied.

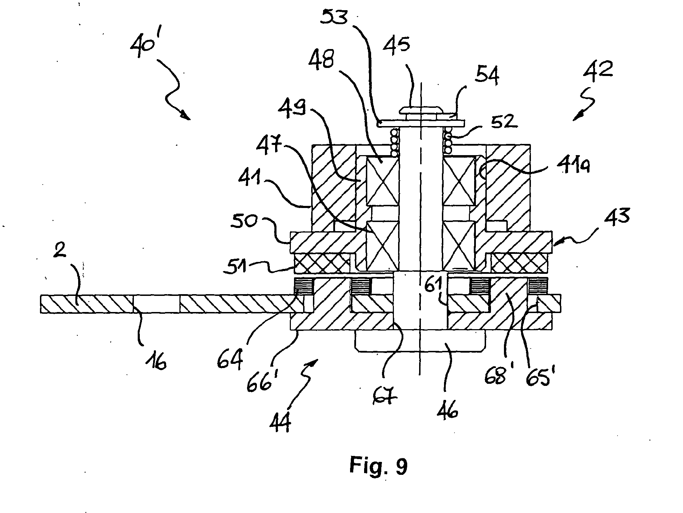

Figures 9-11 illustrate a second embodiment of the scanning device 40' according to the invention, which differs from the first embodiment in that the holes 65' in the PCB 2 are sized to each receive a pin 68' of the support 66', without formation of the seats 69 for receiving the coils 64.

The pins 68' have a greater thickness than the thickness of the PCB 2, so as to project from the PCB 2 on the side of rotor 43 (figure 11).

Also in this case, the pins 68' preferably have a triangular section or other suitably shaped section matching the inner hole of the coils 64, so that the coils 64 can be mounted in an axially symmetric configuration only.

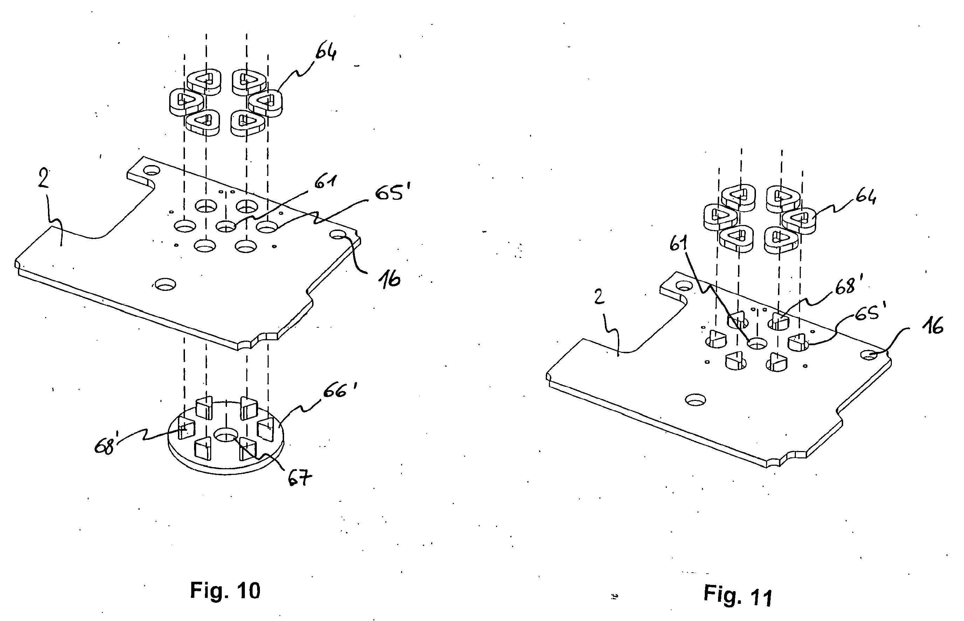

The coils 64 are therefore resting on the PCB 2. Even if the saving of space in the reader 1 is less than the embodiment of figures 10, 11, a casing for the motor is in any case avoided.

Flared holes in the PCB 2 could also be provided so that the pins project and the coils are partially recessed.

It should be understood that the mirror 41 does not necessarily have to be housed above the flange 50, rather can project from the rotor to the level of the PCB 2.

The above teachings can of course also be applied in case of a motor with rotary shaft, the necessary changes being fully within the capability of those skilled in the art.

Although the scanning device 40 has been described with reference to the miniaturized optical code reader of Figures 1-3, it should be understood that it can advantageously be used in optical code readers of other types and configuration.

On the other hand, it should be understood that the preferred embodiment of reader described above has other per se innovative aspects, including its, configuration through two PCBs one of which can be bent and its ability to be fixed with alignment adjustment through elastic rings.

It should be understood that by the reader 1 of the invention it is possible to read linear codes, in particular barcodes and stacked codes (for example PDF 417), but also two-dimensional codes, including characters, providing a second scanning mechanism in the direction perpendicular to the scanning line to form a raster of scanning lines, for example a different inclination of the faces of the polygonal mirror 11, a second oscillating mirror or a relative movement between reader 1 and optical code, like for example in the case of optical codes carried by objects in movement on a conveyor belt, since the extension of the raster pattern in any case falls within the field of view of the optical receiving devices 31.

## Claims

1. Scanning device (40, 40') for an optical code reader (1), comprising a printed circuit board (2), an electric motor (42) having a stator (44), a magnetic rotor (43) and a plurality of coils (64), and a polygonal mirror (41) integral with the rotor (43) of the motor (42), **characterized by** having a support (66, 66') of the coils (64) adjacent to the side of the printed circuit board (2) opposite the magnetic rotor (43) to keep said plurality of coils (64) in positions corresponding to a plurality of holes (65, 65') of the printed circuit board (2).

2. Scanning device (40') according to claim 1, **characterized in that** said support (66') has a corresponding plurality of pins (68') projecting from the holes (65') of the printed circuit board (2), said coils (64) being inserted on the pins (68').

3. Scanning device (40') according to claim 2, **characterized in that** said pins (68') have a non-circular cross section, and the hole of the coils (64) has a corresponding shape.

4. Scanning device (40) according to claim 1, **characterized in that** the holes (65) of the printed circuit board (2) are each sized to receive a respective coil (64).

5. Scanning device (40) according to claim 4, **characterized in that** said support (66) has a corresponding plurality of pins (68) completely received in the holes (65) of the printed circuit board (2) to create seats (69) for receiving the coils (64).

6. Scanning device (40) according to claim 5, **characterized in that** said pins (68') have a non-circular cross section, and the hole of the coils (64) has a corresponding shape.

7. Scanning device (40) according to any of claims 4-6, **characterized in that** said holes (65) of the printed circuit board (2) sized to each receive a coil (64) have a non-circular cross section, the outer cross section of the coils (64) having a corresponding shape.

8. Scanning device (40, 40') according to any of the previous claims, **characterized in that** the motor (42) is of the fixed shaft (45) type.

9. Scanning device (40, 40') according to any of the previous claims, **characterized in that** the polygonal mirror (41) has faces with different inclination with respect to its rotation axis.

10. Scanning section of an optical code reader (1), comprising a scanning device (40, 40') according to any of claims 1-9 and an emitter (10) of a reading light beam.

11. Optical code reader (1) comprising a scanning device (40, 40') according to any of claims 1-9.
